# EUROPEAN PATENT APPLICATION

(11) **EP 1 947 594 A1**
(43) Date of publication of application: **23.07.2008**
(21) Application number: 07001058.2
(22) Date of filing: 18.01.2007
(51) Int. Cl.: G06K 19/077, H01L 21/60, H01L 21/68, H01L 23/498, H01L 21/56

(54) **Circuit carrier laminate and circuit carrier for mounting a semicaonductor chip of a smartcard module, and manufacturing methods thereof**

(71) Applicant: Tyco Electronics AMP GmbH, 64625 Bensheim (DE); Tyco Electronics France SAS, 95300 Pontoise (FR)
(72) Inventor: Liesener, Thomas, 75177 Pforzheim (DE); Morgenthaler, Frédéric, 67470 Seitz (FR); Kalck, Sebastien, 67240 Bischwiller (FR); Daniel, Eric, 45650 Saint Jean Le Blanc (FR)
(74) Representative: Grünecker, Kinkeldey, Stockmair & Schwanhäusser Anwaltssozietät

(57) **Abstract**

The present invention relates to a circuit carrier laminate (100) and a circuit carrier for mounting a semiconductor chip (30) of a smart card module (40), as well as to a smart card module (40) comprising a semiconductor chip (30) and such a circuit carrier. A circuit carrier laminate (100) comprises a contact lead-frame (10) having a first surface that is adapted to electrically contact the semiconductor chip (30) and a second surface that is formed to establish an electrical contact of the smart card module (40) to an external component. In order to obtain a smart card module having a reduced size while guaranteeing reduced production costs, an electrically non-conductive layer (21) is arranged on the first surface of the contact lead-frame (10), wherein an extremity (11) of the electrical contacts of the contact lead-frame (10) is bent and a cavity is formed in the electrically non-conductive layer (21) for enabling a direct mounting of the semiconductor chip (30) on the bent extremity (11) of the electrical contacts of the contact lead-frame (10).

## Description

The present invention relates to a circuit carrier for mounting a semiconductor chip of a smart card module, as well as to a smart card module comprising a semiconductor chip and such a circuit carrier. A circuit carrier comprises a contact lead-frame having a first surface that is adapted to electrically contact the semiconductor chip and a second surface that is formed to establish an electrical contact of the smart card module to an external component. The present invention also relates to a method of manufacturing a circuit carrier laminate, and to a method of assembling a smart card module.

Smart card modules usually comprise a circuit carrier, on which a semiconductor chip is mounted, and a contact lead-frame. The contact lead-frame comprises a plurality of contacts, which can be contacted by an external component such as a smart card reader. The shape and dimensions of the electrical contacts of a smart card are specified by international standards such as e.g. ISO standard 7816. A smart card module is usually embedded into a smart card body to form a chip card.

The methods for mounting and electrically contacting a semiconductor chip on a circuit carrier as well as the structure of the corresponding circuit carrier are diverse. However, two main types of electrical contact of the semiconductor chip on a circuit carrier can be identified, namely the wire-bonding and flip-chip techniques.

According to the wire-bonding technique, which is usually implemented in the conventional smart card modules, the semiconductor chip is connected to the electrical contacts of the smart card module using wire bonds. This technique requires an encapsulation of the semiconductor chip and its wire bonds, to ensure the reliability of the smart card module. However, this contacting technique has the drawback that the smart card module has a complex arrangement, and is relatively bulky. This is a major drawback considering the fact that smart cards have been evolving rapidly towards smaller form factors, especially in the telecommunication area, where e.g. the Subscriber Identity Modules (SIM cards) have seen their dimensions decrease quite dramatically. This evolution thus leads to a need for reducing the size of the smart card module.

The second type of method of interconnecting a semiconductor chip with a circuit carrier is the flip-chip technique. After having been long used in the automotive industry, the flip-chip interconnecting method is being more and more implemented in the computer and telecommunication areas, for its advantages in terms of size, cost and performance. In contrast to the wire bonding technique, the flip-chip technique does not require any wire bonds. Instead, a semiconductor chip, preferentially in the form of an integrated circuit die, is mounted upside down on a substrate, the pads of the semiconductor chip being turned ("flipped") toward the circuit carrier side when mounting the semiconductor chip on the circuit carrier. The electrical interconnection is made using conductive material, so-called bumps, made out of gold or a gold alloy, that are located between the chip contacts and the circuit carrier. The semiconductor chip is glued on the surface of the circuit carrier by means of an adhesive, referred to as flip-chip adhesive. As this technique does not require an encapsulation, the size of the smart card module can be reduced dramatically.

In the German patent application published under the number 10 2005 028 494, and owned by the applicant of the present application, a circuit substrate for providing a carrier for a semiconductor chip is disclosed, which allows a semiconductor chip to be mounted thereon using the flip-chip technique. The circuit substrate comprises a contact lead-frame for an electrical contact with an external component, such as a smart card reader, and a flip-chip lead-frame, on which the semiconductor chip is mounted, wherein the contact lead-frame and flip-chip lead-frame are connected to each other.

However, such a circuit substrate leads to a bulky smart card module, which has a complicated arrangement, due in particular to the structure in two different lead-frames and to the several elements that form the flip-chip lead-frame. Further, the several elements of the flip-chip lead-frame and the contact lead-frame have to be connected to each other using laser welding, thus rendering the manufacturing process particularly complicated.

It is therefore an object of the invention to provide a circuit carrier for mounting a semiconductor chip of a smart card module that allows for obtaining a smart card module having a reduced size while guaranteeing reduced production costs.

This object is solved by the subject matter of the independent claims. Preferred embodiments are subject matter of the dependent claims.

According to an aspect of the invention, a circuit carrier laminate for mounting a semiconductor chip of a smart card module is provided, wherein said circuit carrier laminate comprises a contact lead-frame having a first surface that is adapted to electrically contact the semiconductor chip and a second surface that is formed to establish an electrical contact of the smart card module to an external component, and an electrically non-conductive layer that is arranged on the first surface of the contact lead-frame, wherein an extremity of the electrical contacts of the contact lead-frame is bent and a cavity is formed in the electrically non-conductive layer for enabling a direct mounting of the semiconductor chip on the bent extremity of the electrical contacts of the contact lead-frame.

The provision of an electrically non-conductive layer that is arranged on the first surface of the contact lead-frame allows for ensuring the mechanical stability of the electrical contacts of the contact lead-frame during the manufacturing process. Forming a cavity in the electrically non-conductive layer for enabling a direct mounting of the semiconductor chip on the bent extremity of the electrical contacts of the contact lead-frame allows a semiconductor chip to be arranged directly on the contact lead-frame without an intermediate electrically non-conductive layer, thereby allowing to reduce the thickness of the circuit carrier, and, in turn, that of the smart card module. This embodiment is particularly advantageous for semiconductor chips whose dimensions are larger than the size of the electrical contacts of the contact lead-frame.

In comparison to a conventional flip-chip connection of a semiconductor chip on a circuit carrier, where vias have to be foreseen through an insulating substrate to ensure the electrical contact of the semiconductor chip with the electrical contacts of the lead-frame, a circuit carrier according to this aspect of the invention can be produced in a more costeffective manner, as vias do not have to be foreseen in a substrate. In fact, since the semiconductor chip is directly connected on the bent extremities of the electrical contacts of the contact lead-frame, there is no need for vias any more, thereby simplifying the structure of the circuit carrier. The bending of the contact lead-frame is rendered possible by the newest material bending techniques, which allow to bend extremities of a contact lead-frame on a very thin distance, e.g. of the order of 50 µm, thereby leading to a reduced thickness of the circuit carrier and smart card module.

According to a preferred embodiment of the invention, the circuit carrier laminate further comprises a second laminated electrically non-conductive layer that is arranged on the second surface of the contact lead-frame and is removable after mounting the semiconductor chip on the circuit carrier.

The provision of a second laminated electrically non-conductive layer on the second surface of the contact lead-frame allows for connecting the semiconductor chip directly on the first surface of the contact lead-frame using the flip-chip technique, since the second laminated electrically non-conductive layer protects the electrical contacts on the second surface of the contact lead-frame from any contamination due to the flip-chip adhesive that could flow through the spaces between the electrical contacts. Further, the second laminated electrically non-conductive layer protects the electrical contacts of the contact lead-frame from damage, especially from its surface being scratched during the manufacturing process, thereby guaranteeing a high surface quality on the delivery to the customer.

Consequently, a circuit carrier according to an embodiment of the invention has a reduced thickness with respect to a circuit carrier according to the art, and can be produced in a simple manner and with reduced production costs.

According to a preferred embodiment of the invention, the electrically non-conductive layer is one of a dielectric layer, preferentially polyethylene terephthalate, or an aluminium layer with an electrically non-conductive coating. This allows a particularly simple manufacturing process, which is compatible with a production in high numbers and a reel-to-reel manufacturing process.

According to a further preferred embodiment of the invention, the second laminated electrically non-conductive layer is one of a dielectric layer, preferentially polyethylene terephthalate, or an aluminium layer with an electrically non-conductive coating. Likewise, this allows a particularly simple manufacturing process, which is compatible with a production in high numbers and a reel-to-reel manufacturing process.

According to another embodiment of the invention, the circuit carrier laminate comprises a plurality of contact lead-frames that are individualizable. Accordingly, the circuit carriers only need to be individualized after mounting of the semiconductor chips thereon and assembly into a smart card body, thereby allowing a production in high numbers and according to a reel-to-reel process.

According to another aspect of the invention, a circuit carrier for mounting a semiconductor chip of a smart card module is provided, which comprises a contact lead-frame having a first surface that is adapted to electrically contact the semiconductor chip and a second surface that is formed to establish an electrical contact of the smart card module to an external component, and an electrically non-conductive layer that is arranged on the first surface of the contact lead-frame wherein an extremity of the electrical contacts of the contact lead-frame is bent and a cavity is formed in the electrically non-conductive layer for enabling a direct mounting of the semiconductor chip on the bent extremity of the electrical contacts of the contact lead-frame. Such a circuit carrier allows for a semiconductor chip to be directly mounted on the first surface of the contact lead-frame, preferentially using the flip-chip technique.

According to another embodiment of the invention, a smart card module is provided which comprises a circuit carrier according to an embodiment of the invention, a semiconductor chip that is mounted on the circuit carrier, and a smart card body in which the semiconductor chip mounted on the circuit carrier is embedded. Accordingly, such a smart card module has reduced dimensions with respect to a circuit carrier according to the art.

According to a preferred embodiment of the invention, the semiconductor chip is connected electrically to the circuit carrier using the flip-chip technique. Hence, the semiconductor chip is directly glued on the first surface of the contact lead-frame using a flip-chip adhesive. However, the semiconductor chip may also be connected to the circuit carrier using the wire bonding technique. Hence, according to an alternative embodiment of the invention, the semiconductor chip is wire-bonded on the first surface of the contact lead-frame.

According to another aspect of the invention, a method of manufacturing a circuit carrier laminate for mounting a semiconductor chip of a smart card module is provided, wherein the method comprises forming a contact lead-frame having a first surface for electrically contacting the semiconductor chip and a second surface for establishing an electrical contact of the smart card module to an external component, bending an extremity of the electrical contacts of the contact lead-frame, arranging an electrically non-conductive layer on the first surface of the contact lead-frame, and forming a cavity in the electrically non-conductive layer for enabling a direct mounting of the semiconductor chip on the bent extremity of the electrical contacts of the contact lead-frame.

According to a preferred embodiment of the invention, the circuit carrier laminate is manufactured in a reel-to-reel process.

According to another embodiment of the invention, a method of assembling a smart card module is provided, comprising mounting a semiconductor chip on a circuit carrier of the circuit carrier laminate manufactured according to an embodiment of the invention, and embedding the circuit carrier mounted with the semiconductor chip into a smart card body.

The present invention will be described in detail in the following based on the figures enclosed with this application.
- Fig. 1: is an overview of a circuit carrier laminate according to an embodiment of the invention;
- Fig. 2: is a side view of a circuit carrier according to one embodiment of the invention;
- Fig. 3: is a side view of the circuit carrier shown in Fig. 1 in a further step of the manufacturing process;
- Fig. 4: is a side view of the circuit carrier shown in Fig. 3, on which a semiconductor chip has been mounted.

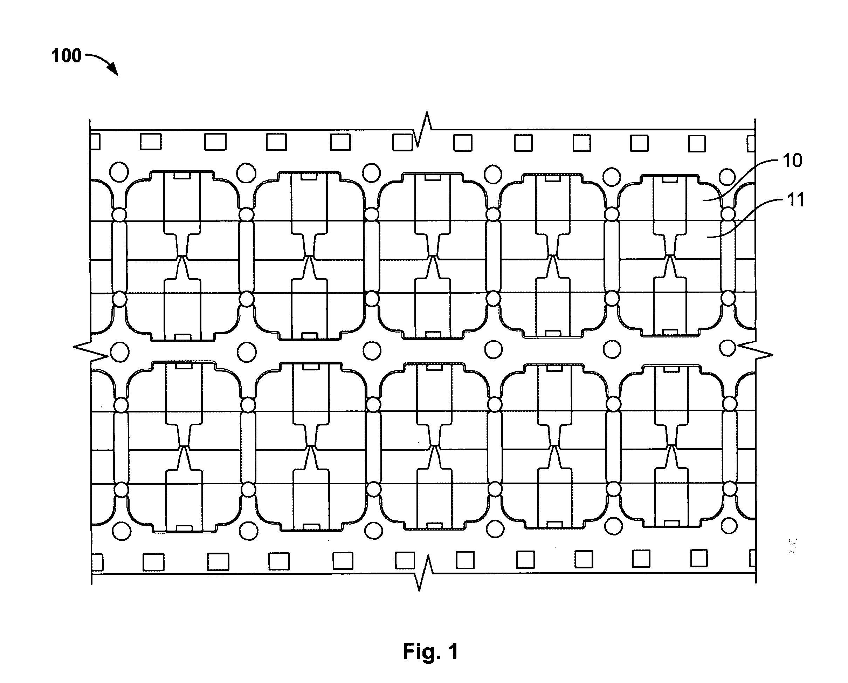

Fig. 1 shows an overview of a circuit carrier laminate 100 according to an embodiment of the invention. The circuit carrier laminate 100 is preferentially foreseen as a reel that can be made out of different types of conductive material, such a copper or copper alloys. According to an embodiment of the invention, the reel may be made out of CuFe2P. The circuit carrier laminate 100 comprises a plurality of contact lead-frames 10 that are individualizable. The lead-frames 10 are first stamped before being plated, in order to increase their conductive properties. The lead-frames 10 may be plated with e.g. nickel or gold.

The circuit carrier laminate 100 is preferentially produced in a reel-to-reel process, thus producing a reel of contact lead-frames 10. Even though Fig. 1 shows a portion of reel having two circuit carriers arranged across the width of the reel, it may be appreciated that a reel having only one circuit carrier across its width or any other number could be considered by a person skilled in the art.

Each contact lead-frame 10 has a first surface (not represented in Fig. 1) for contacting a semiconductor chip. The contact lead-frame 10 further comprises a second surface having the electrical contacts of the smart card module that are adapted to contact an external component such as a smart card reader, said second surface being represented in Fig. 1. The plurality of electrical contacts of the contact lead-frame 10 are arranged according to a predetermined arrangement, depending on the international standard for smart cards to be employed.

According to an embodiment of the invention, the extremities 11 of the electrical contacts of the contact lead-frames 10 are bent downward. As apparent from Fig. 1, two bending separations, one across each set of three electrical contacts arranged on each side of one lead-frame 10, are visible.

According to an embodiment of the invention, an electrically non-conductive layer may be laminated on the second surface of the lead-frame 10. The laminated electrically non-conductive layer can be a dielectric layer, preferentially polyethylene terephthalate (PET) or polyethylene naphthalate (PEN). Alternatively, the laminated electrically non-conductive layer may be an aluminium layer with an electrically non-conductive coating arranged thereon.

Even though the electrical contacts of the contact lead-frames 10 shown in Fig. 1 are represented with the specific arrangement of six electrical contacts within one contact lead-frame, it is apparent from the description above that an arrangement with eight electrical contacts within one contact lead-frame can also be used in combination with the present invention.

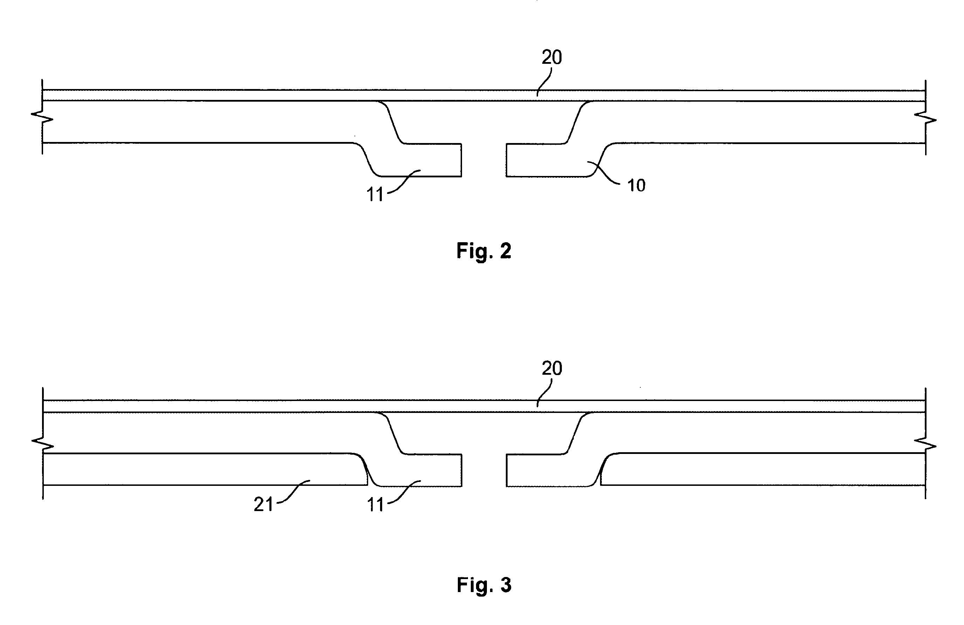

In the following, a method of manufacturing a circuit carrier laminate and a method of assembling a smart card module according to embodiments of the invention will be described with respect to Figs. 2 to 4.

Fig. 2 shows a side view of a circuit carrier according to an embodiment of the invention. It shows the lead-frame 10 with the bent extremities 11 of the electrical contacts. An electrically non-conductive layer 20 is laminated on the second surface of the lead-frame 10. The laminated electrically non-conductive layer 20 may be foreseen on the whole second surface of the lead-frame 10 of the circuit carrier laminate 100.

Alternatively, the electrically non-conductive layer 20 may be foreseen only on the bent extremities 11 of each contact lead-frame 10. Indeed, this area is the area where the flip-chip adhesive, which is used to glue the semiconductor chip on the first surface of the contact lead-frame, could flow, thereby leading to the risk of contaminating the surface of the electrical contacts of the contact lead-frames 10. Further, foreseeing the laminated electrically non-conductive layer only in the bent extremities 11 of the contact lead-frame 10 allows to reduce the quantity of dielectric material, e.g. PET, necessary in the manufacturing process of the circuit carrier laminate 100, thereby reducing the manufacturing costs.

Fig. 3 shows a side view of the circuit carrier shown in Fig. 2. A further electrically non-conductive layer 21 is arranged on the first surface of the contact lead-frame 10. The electrically non-conductive layer 21 can be made out of dielectric material, preferentially polyethylene terephthalate or polyethylene naphthalate. Alternatively, the second electrically non-conductive layer 21 may be an aluminum layer with an electrically non-conductive coating provided thereon.

The electrically non-conductive layer 21 is stamped in such a way that a cavity is formed whose width corresponds to the combined width of the bent extremities 11 of the lead-frame 10. Further, the thickness of the electrically non-conductive layer 21 corresponds essentially to the thickness of the bent extremities 11 of the contact lead-frame 10. Hence, the stamped electrically non-conductive layer 21 is arranged on the first surface of the lead-frame 10, so that the bent extremities 11 of the lead-frame 10 and the electrically non-conductive layer 21 have an essentially planar surface.

A semiconductor chip, whose dimensions are larger than a size of the electrical contacts of the contact lead-frame 10 can thus be directly mounted onto the bent extremity 11 of the electrical contacts of the contact lead-frame 10.

The provision of the laminated electrically non-conductive layer 20 allows the electrical contacts of the lead-frame 10 to be held together, thereby assuring that the electrical contacts of the contact lead-frame 10 remain in a predetermined arrangement. This predetermined arrangement may comply with one of the international standards for smart cards, such as ISO 7816. Alternatively, the electrically non-conductive layer 21 may assure the mechanical stability of the electrical contacts of the contact lead-frame 10.

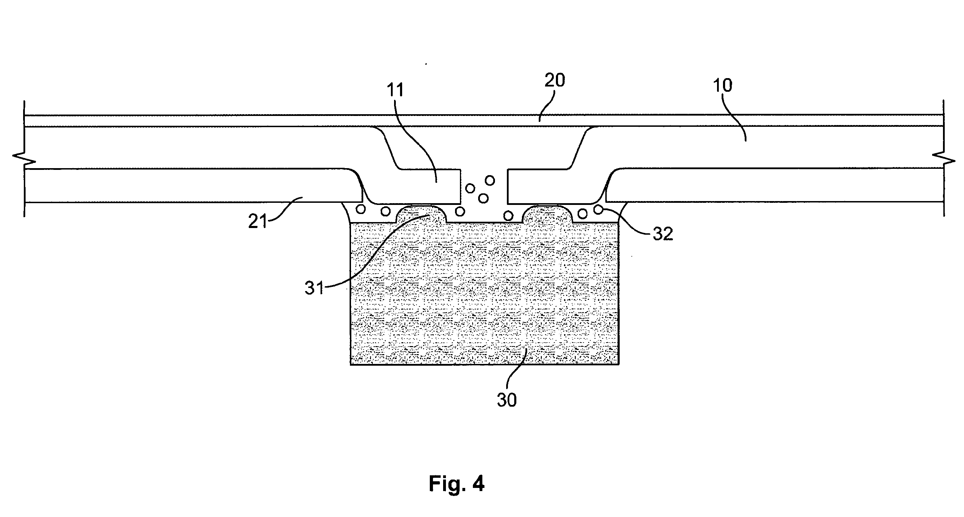

Fig. 4 shows a side view of the circuit carrier shown in Fig. 3, wherein a semiconductor chip 30 has been mounted thereon. The semiconductor chip 30 is mounted on the first surface of the lead-frame 10. The semiconductor chip 30 is directly glued on the lead-frame 10 using a flip-chip adhesive 32. Bumps 31 provided on the semiconductor chip 30 ensure the electrical connection to the lead-frame 10. The arrangement of the circuit carrier mounted with the semiconductor chip 30 can then be embedded into a smart cart module (not represented).

Even though the present invention is preferentially implemented using a flip-chip interconnection technique of the semiconductor chip 30 with the lead-frame 10, it may also be envisaged to connect the semiconductor chip 30 using the wire bonding technique.

The step of removing the laminated electrically non-conductive layer 20 is preferentially performed after the lead-frames 10 have been individualized from the circuit carrier laminate 100. Hence, the surface of the electrical contacts of the lead-frames 10 is protected from mechanical damage until delivery of the circuit carrier laminate 100 (e.g. as a reel) to a smart card manufacturer. After assembly of the semiconductor chip onto the circuit carrier and embedding into the smart card body, the laminated electrically non-conductive layer can be removed.

### List of reference signs:

- 10: contact lead-frame
- 11: extremities of the electrical contacts of the contact lead-frame
- 20: laminated electrically non-conductive layer
- 21: second electrically non-conductive layer
- 30: semiconductor chip
- 31: bumps
- 32: flip-chip adhesive
- 40: smartcard body
- 100: circuit carrier laminate

## Claims

1. Circuit carrier laminate for mounting a semiconductor chip (30) of a smart card module (40), said circuit carrier laminate (100) comprising:
a contact lead-frame (10) having a first surface that is adapted to electrically contact the semiconductor chip (30) and a second surface that is formed to establish an electrical contact of the smart card module (40) to an external component, and
an electrically non-conductive layer (21) that is arranged on the first surface of the contact lead-frame (10),
wherein an extremity (11) of the electrical contacts of the contact lead-frame (10) is bent and a cavity is formed in the electrically non-conductive layer (21) for enabling a direct mounting of the semiconductor chip (30) on the bent extremity (11) of the electrical contacts of the contact lead-frame (10).

2. The circuit carrier laminate according to claim 1, further comprising a second laminated electrically non-conductive layer (20) that is arranged on the second surface of the contact lead-frame (10) and is removable after mounting the semiconductor chip (30) on the circuit carrier.

3. The circuit carrier laminate according to claim 2, wherein one of the electrically non-conductive layer (21) and the second laminated electrically non-conductive layer (20) is adapted to hold the plurality of electrical contacts of the contact lead-frame (10) in a predetermined arrangement.

4. The circuit carrier laminate according to claim 3, wherein the predetermined arrangement corresponds to one of the international standards for smart cards, preferentially ISO 7816.

5. The circuit carrier laminate according to one of claims 1 to 4, wherein the electrically non-conductive layer (21) is one of a dielectric layer, preferentially Polyethylene terephthalate, or an aluminium layer with a second electrically non-conductive coating.

6. The circuit carrier laminate according to one of claims 2 to 5, wherein the second laminated electrically non-conductive layer (20) is one of a dielectric layer, preferentially Polyethylene terephthalate, or an aluminium layer with an electrically non-conductive coating.

7. The circuit carrier laminate according to one of claims 1 to 6, further comprising a plurality of contact lead-frames (10) that are individualizable.

8. Circuit carrier for mounting a semiconductor chip (30) of a smart card module (40), said circuit carrier comprising:
a contact lead-frame (10) having a first surface that is adapted to electrically contact the semiconductor chip (30) and a second surface that is formed to establish an electrical contact of the smart card module (40) to an external component, and
an electrically non-conductive layer (21) that is arranged on the first surface of the contact lead-frame (10),
wherein an extremity (11) of the electrical contacts of the contact lead-frame (10) is bent and a cavity is formed in the electrically non-conductive layer (21) for enabling a direct mounting of the semiconductor chip (30) on the bent extremity (11) of the electrical contacts of the contact lead-frame (10).

9. The circuit carrier according to claim 8, wherein the electrically non-conductive layer (21) is one of a dielectric layer, preferentially Polyethylene terephthalate, or an aluminium layer with an electrically non-conductive coating.

10. A smart card module comprising:
a circuit carrier according to claim 8 or 9,
a semiconductor chip (30) that is mounted on the circuit carrier, and
a smart card body (40) in which the semiconductor chip (30) mounted on the circuit carrier is embedded.

11. The smart card module according to claim 10, wherein the semiconductor chip (30) is directly glued on the first surface of the contact lead-frame (10) using a flip-chip adhesive (32).

12. The smart card module according to claim 10, wherein the semiconductor chip (30) is wire-bonded on the first surface of the contact lead-frame (10).

13. A method of manufacturing a circuit carrier laminate (100) for mounting a semiconductor chip (30) of a smart card module (40), said method comprising the steps of:
forming a contact lead-frame (10) having a first surface for electrically contacting the semiconductor chip (30) and a second surface for establishing an electrical contact of the smart card module (40) to an external component,
bending an extremity (11) of the electrical contacts of the contact lead-frame (10),
arranging an electrically non-conductive layer (21) on the first surface of the contact lead-frame (10), and
forming a cavity in the electrically non-conductive layer (21) for enabling a direct mounting of the semiconductor chip (30) on the bent extremity (11) of the electrical contacts of the contact lead-frame (10).

14. The method according to claim 13, further comprising forming a plurality of contact lead-frames (10) that are individualizable.

15. The method according to claim 13 or 14, further comprising laminating a removable electrically non-conductive layer (20) on the second surface of the contact lead-frame (10).

16. The method according to one of claims 13 to 15, wherein the circuit carrier laminate (100) is manufactured in a reel-to-reel process.

17. A method of assembling a smart card module (40), said method comprising the steps of:
mounting a semiconductor chip (30) on a circuit carrier of the circuit carrier laminate (100) manufactured according to one of claims 13 to 16, and
embedding the circuit carrier mounted with the semiconductor chip (30) into a smart card body (40).

18. The method according to claim 17, further comprising individualizing the embedded smart card body (40).

19. The method according to claim 17 or 18, further comprising removing the laminated removable electrically non-conductive layer (20) from the second surface of the contact lead-frame (10).
